# FASCICULE DE BREVET EUROPEEN

(11) **EP 2 533 618 B1**
(45) Date de publication et mention de la délivrance du brevet: **17.01.2018**
(21) Numéro de dépôt: 12170732.7
(22) Date de dépôt: 04.06.2012
(51) Int. Cl.: H05K 5/06, H02M 7/00

(54) **Dispositif de conversion d'énergie électrique comprenant un module de puissance, une enceinte étanche et des organes de maintien du module dans l'enceinte, avec au moins trois organes de maintien successifs selon la direction longitudinale**
Vorrichtung zur Umwandlung von elektrischer Energie, die ein Leistungsmodul, einen dichten Behälter und Organe zur Befestigung des Moduls im Behälter umfasst, mit mindestens drei in Längsrichtung nacheinander angeordneten Befestigungsoganen
Electric power conversion device comprising a power module, a sealed enclosure and members for holding the module inside the enclosure, with at least three consecutive holding members in the longitudinal direction

(30) Priorité: 07.06.2011 FR 1154935
(43) Date de publication de la demande: 12.12.2012
(73) Titulaire: GE Energy Power Conversion Technology Limited, Rugby Warwickshire CV21 1BU (GB)
(72) Inventeur: Baerd, Henri, 77430 CHAMPAGNE SUR SEINE (FR); Renaud, Guillaume, 91300 MASSY (FR)
(74) Mandataire: Serjeants LLP

(56) Documents cités:
- EP-A1- 1 310 759
- EP-A1- 2 234 468
- FR-A1- 2 711 300
- US-A1- 2010 208 446

## Description

La présente invention concerne un dispositif de conversion d'énergie électrique pour un système d'entraînement électrique de station sous-marine de compression et de pompage, du type comprenant:
- un module électrique de puissance,
- une enceinte étanche de logement du module de puissance, l'enceinte étanche s'étendant selon une direction longitudinale,
- une pluralité d'organes de maintien du module électrique à l'intérieur de l'enceinte étanche, les organes de maintien étant disposés en N positions longitudinales successives selon la direction longitudinale.

La présente invention s'applique notamment à un dispositif de conversion d'énergie électrique propre à être immergé à une profondeur supérieure à 50m.

L'invention concerne également un procédé de fabrication d'un tel dispositif de conversion d'énergie électrique.

On connaît un dispositif de conversion du type précité. L'enceinte étanche comporte trois tronçons successifs suivant la direction longitudinale, à savoir un tronçon intermédiaire et deux tronçons d'extrémité disposés de part et d'autre du tronçon intermédiaire. Les tronçons sont mobiles entre une position de fermeture de l'enceinte dans laquelle les tronçons sont fixés les uns aux autres et une position d'ouverture de l'enceinte dans laquelle les tronçons sont à l'écart les uns des autres. Le module électrique de puissance comporte une ossature mécanique à laquelle sont fixés les différents équipements électriques du module de puissance. L'ossature mécanique s'étend selon la direction longitudinale, et présente une section hexagonale suivant un plan transversal perpendiculaire à la direction longitudinale. Le module électrique de puissance est, en chacune de ses deux extrémités longitudinales, maintenu au tronçon intermédiaire de l'enceinte étanche.

Toutefois, la masse d'un tel dispositif de conversion est très élevée, par exemple supérieure à 100 tonnes, ce qui engendre des contraintes importantes lors du transport maritime du dispositif de conversion, puis lors de son immersion. Le document "EP 2 234 468 A1" divulgue un dispositif de conversion d'énergie électrique pour un système d'entraînement électrique de station sous-marine de compression et de pompage, selon le préambule de la revendication 1. Le but de l'invention est donc de proposer un dispositif de conversion d'énergie de masse plus faible, tout en délivrant une même puissance électrique.

A cet effet, l'invention a pour objet un dispositif de conversion du type précité, caractérisé en ce que le nombre N de positions longitudinales successives est un nombre entier supérieur ou égal à 3.

Suivant d'autres modes de réalisation, le dispositif de conversion comprend une ou plusieurs des caractéristiques suivantes, prises isolément ou selon toutes les combinaisons techniquement possibles :
- le module électrique de puissance comprend une ossature mécanique comportant deux poutres sensiblement longitudinales et au moins deux poutres transversales, chaque poutre transversale reliant mécaniquement les deux poutres longitudinales,
- la masse linéique des poutres de l'ossature mécanique est inférieure à 100 kg/m, de préférence inférieure à 80 kg/m, de préférence encore inférieure à 60 kg/m,
- le module électrique de puissance comprend en outre au moins un plateau transversal agencé perpendiculairement aux poutres longitudinales, le ou chaque plateau transversal étant solidaire des deux poutres longitudinales,
- les organes de maintien sont disposés au voisinage de chacune des extrémités des poutres longitudinales et également en regard d'au moins un plateau transversal disposé à l'écart des extrémités des poutres longitudinales,
- les organes de maintien sont disposés en regard d'une pluralité de plateaux transversaux disposés à l'écart des extrémités des poutres longitudinales,
- N est un nombre entier supérieur ou égal à 5,
- l'enceinte étanche comporte au moins deux tronçons successifs suivant la direction longitudinale, et le ou les organe(s) de maintien disposé(s) en l'une des deux positions longitudinales extrêmes comporte(nt) des moyens de suspension à un tronçon correspondant,
- les organes de maintien disposés en des positions longitudinales autres que ladite position longitudinale extrême comportent des moyens d'appui contre l'enceinte ; et
- au moins une paire d'organes de maintien est agencée en une position longitudinale autre que ladite position longitudinale extrême, les moyens d'appui de la ou chaque paire d'organes de maintien étant diamétralement opposés par rapport à un axe médian du module, l'axe médian étant parallèle à la direction longitudinale.

L'invention a également pour objet un procédé de fabrication d'un dispositif tel que défini ci-dessus, comprenant les étapes suivantes :
- le transport du module électrique de puissance jusqu'au voisinage de l'enceinte,
- l'insertion du module électrique de puissance dans l'enceinte, et
- la fermeture de l'enceinte étanche, le procédé étant caractérisé en ce qu'il comprend l'utilisation d'un outil de maintien du module de puissance lors de l'étape de transport, et en ce que les organes de maintien maintiennent le module électrique à l'intérieur de l'outil de maintien lors de l'étape de transport.

Ces caractéristiques et avantages de l'invention apparaîtront à la lecture de la description qui va suivre, donnée uniquement à titre d'exemple, et faite en référence aux dessins annexés, sur lesquels :
- la figure 1 est une vue de face d'un dispositif de conversion selon l'invention, comprenant un module électrique de puissance et une enceinte étanche de logement du module de puissance,
- la figure 2 est une vue en coupe suivant le plan II de la figure 1,
- la figure 3 est une vue en coupe suivant le plan III de la figure 2, et
- la figure 4 est une vue en perspective d'une ossature mécanique du module de puissance de la figure 1.

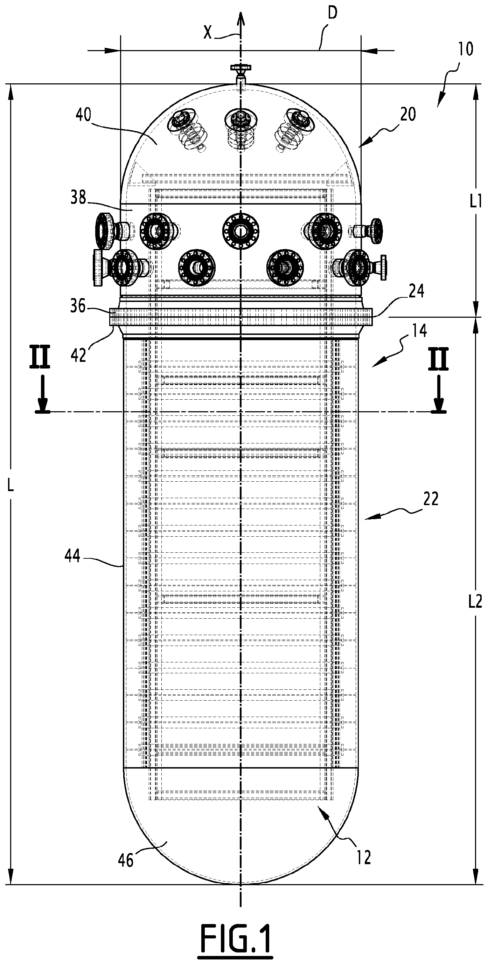

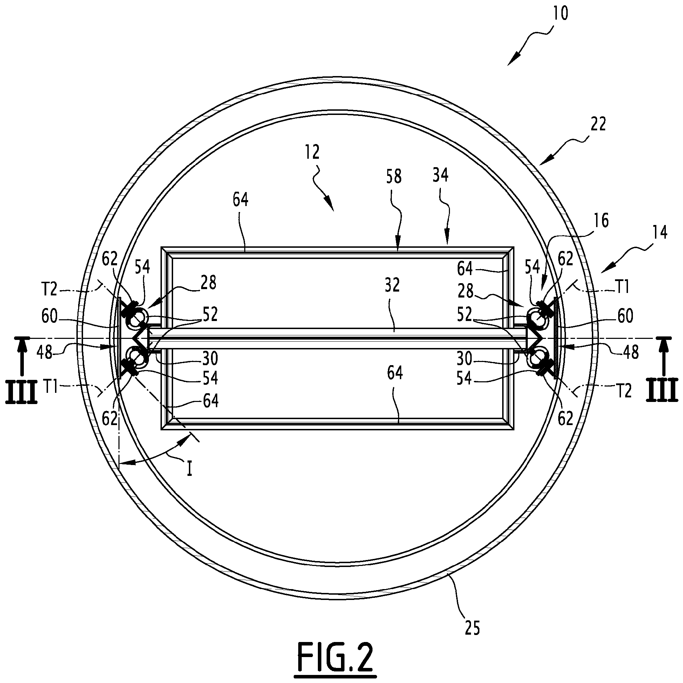

Sur les figures 1 et 2, un dispositif de conversion d'énergie électrique 10 comprend un module électrique de puissance 12, une enceinte étanche 14 de logement du module de puissance, l'enceinte étanche 14 s'étendant selon une direction longitudinale X, et une pluralité d'organes 16 de maintien du module électrique à l'intérieur de l'enceinte étanche.

Le dispositif de conversion 10 est destiné à alimenter un système, non représenté, d'entraînement électrique de station sous-marine de compression et de pompage.

Le dispositif de conversion 10 est destiné à être immergé à une profondeur supérieure à 50 mètres, par exemple comprise entre 1000 mètres et 3000 mètres. Le dispositif de conversion 10 résiste alors à une pression extérieure supérieure à 6 bars, par exemple comprise entre 100 bars et 300 bars.

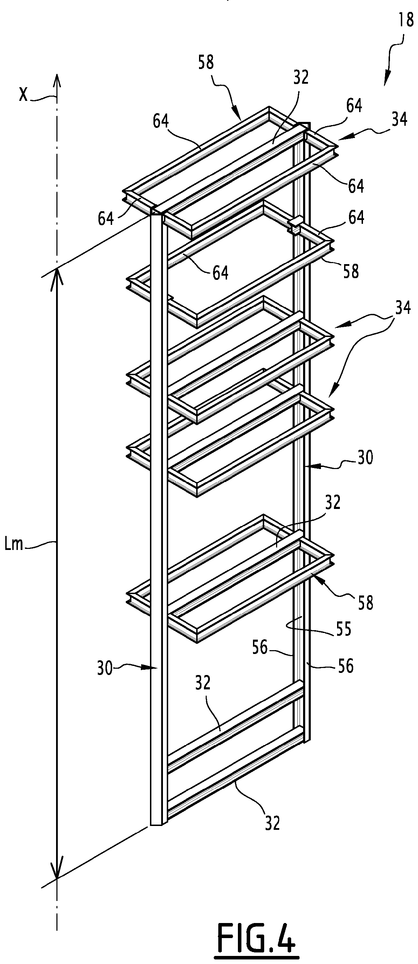

Le module électrique de puissance 12 comporte une ossature mécanique 18, représentée en pointillés sur la figure 1 et visible sur la figure 4, et des équipements électriques de puissance, non représentés, solidaires de l'ossature mécanique 18.

Le module de puissance 12 présente une longueur Lm selon la direction longitudinale X, comme représenté sur la figure 4. La longueur Lm est, par exemple, supérieure ou égale à 2m, de préférence supérieure ou égale à 5m.

Le module électrique de puissance 12 présente une puissance électrique élevée, telle qu'une puissance électrique de valeur supérieure à 100 kW, de préférence supérieure à 1 MW.

L'enceinte étanche 14 est au moins partiellement en forme d'un cylindre et présente un diamètre D de valeur comprise entre un et trois mètres, comme représenté sur la figure 1. L'enceinte étanche 14 présente une longueur L selon la direction longitudinale X. La longueur L est, par exemple, de l'ordre de dix mètres.

L'enceinte étanche 14 comporte au moins deux tronçons 20, 22 successifs suivant la direction longitudinale X, et mobiles entre une position de fermeture de l'enceinte 14 dans laquelle les tronçons 20, 22 sont fixés les uns aux autres (figure 1) et une position d'ouverture de l'enceinte 14 dans laquelle les tronçons 20, 22 sont à l'écart les uns des autres.

Dans l'exemple de réalisation de la figure 1, l'enceinte 14 comporte un premier tronçon 20, également appelé tronçon d'extrémité, et un second tronçon 22, également appelé tronçon principal, et un joint d'étanchéité 24 agencé entre les deux tronçons 20, 22.

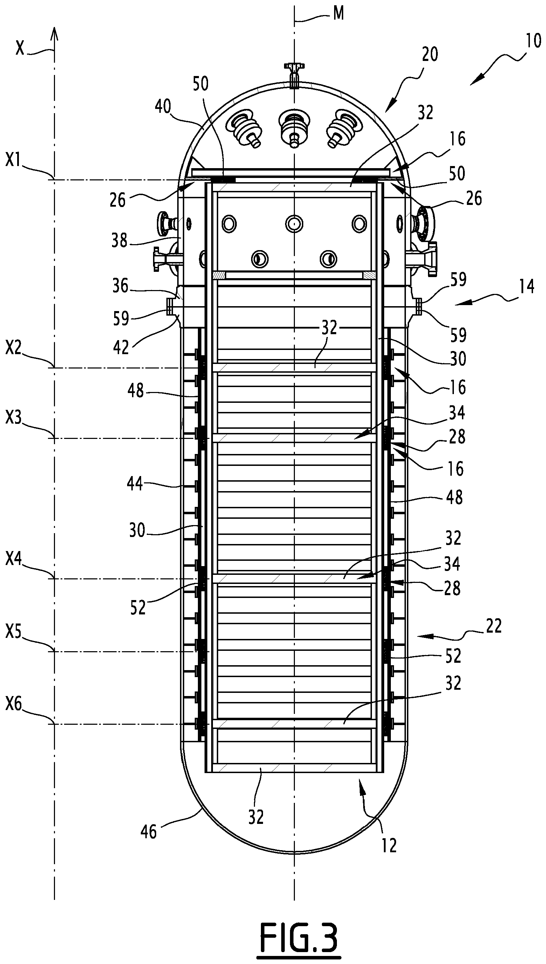

Les organes de maintien 16 sont disposés en N positions longitudinales X1, X2, X3, X4, X5, X6 successives selon la direction longitudinale X, comme représenté sur la figure 3. Les positions longitudinales sont également notées Xi, où i représente l'indice de la position longitudinale, et est un nombre entier compris entre 1 et N. Le nombre N de positions longitudinales Xi est un nombre entier supérieur ou égal à 3.

Le nombre N est de préférence un nombre entier supérieur ou égal à 5.

Dans l'exemple de réalisation de la figure 3, le nombre N est égal à 6.

La distance maximale entre deux positions longitudinales successives Xi, X(i+1) est inférieure à 2,5m.

Les organes de maintien 16 disposés en la position longitudinale extrême X1 comportent des moyens 26 de suspension du module de puissance 12 au premier tronçon 20.

Les organes de maintien 16 disposés en des positions longitudinales X2 à X6 autres que ladite position longitudinale extrême X1 comportent des moyens 28 d'appui contre l'enceinte 14.

Le nombre P d'organe(s) de maintien 16 disposé(s) sensiblement dans un même plan transversal perpendiculaire à la direction longitudinale X est un nombre entier, par exemple compris entre 1 et 6, de préférence inférieur ou égal à 2. Le ou les organe(s) de maintien 16 disposé(s) sensiblement dans un même plan transversal présente(nt) une même position longitudinale Xi selon la direction longitudinale X.

Le nombre P d'organes de maintien 16 dans un même plan transversal est notamment fonction de la forme de la section de l'ossature mécanique 18 selon un plan transversal perpendiculaire à la direction longitudinale X. Dans l'exemple de réalisation de la figure 2, l'ossature mécanique 18 est essentiellement disposée dans un plan médian de l'enceinte 14 auquel appartient la direction longitudinale X, et le nombre P est alors égal à 2.

L'ossature mécanique 18, visible sur les figures 2 et 4, comprend deux poutres 30 sensiblement longitudinales, également appelées longerons, et au moins deux poutres transversales 32, sensiblement perpendiculaires aux poutres longitudinales 30, chaque poutre transversale 32, également appelée traverse, reliant mécaniquement les deux longerons 30. Les longerons 30 et les traverses 32 forment un cadre disposé dans un plan médian de l'enceinte étanche 14.

En complément, l'ossature mécanique 18 comprend au moins un plateau transversal 34 agencé perpendiculairement aux longerons 30, le ou chaque plateau transversal 34 étant solidaire des deux longerons 30. Dans l'exemple de réalisation de la figure 4, l'ossature mécanique 18 comprend cinq plateaux transversaux 34.

L'ossature mécanique 18 du module de puissance est solidaire du premier tronçon 20. L'ossature mécanique 18 est reliée à l'intérieur du premier tronçon 20 par l'intermédiaire des moyens de suspension 26.

L'ossature mécanique 18 présente une masse inférieure à 5 tonnes, de préférence inférieure à 3 tonnes. Dans l'exemple de réalisation de la figure 4, la masse de l'ossature mécanique 18 est égale à 1,5 tonnes.

L'ossature mécanique 18 est, par exemple, réalisée en acier, en acier inoxydable, en aluminium, ou encore en matériau composite, tel que le carbone ou la fibre de verre.

Chaque organe de maintien 16 comporte au moins une liaison mécanique, la ou chaque liaison mécanique d'un organe de maintien 16 respectif étant reliée à une unique poutre 30, 32 du module de puissance 12.

Dans l'exemple de réalisation des figures 1 à 3, chaque organe de maintien 16 est solidaire d'un longeron 30 respectif.

Les organes de maintien 16 sont disposés au voisinage de chacune des extrémités des longerons 30, par exemple à une distance inférieure à un mètre desdites extrémités, les positions longitudinales extrêmes correspondantes étant les positions X1 et X6. Les organes de maintien 16 sont également disposés au regard d'au moins un plateau transversal 34 disposé à l'écart des extrémités des longerons 30.

Dans l'exemple de réalisation de la figure 3, les organes de maintien 16 sont disposés en regard d'une pluralité de plateaux transversaux 34 disposés à l'écart des extrémités des longerons 30, en les positions longitudinales X2, X3 et X4.

En variante, au moins un organe de maintien 16 est solidaire d'une traverse 32 respective.

Le premier tronçon 20, visible sur les figures 1 et 3, comprend une première bride 36 de fixation du premier tronçon au deuxième tronçon, une partie cylindrique 38 fixée à la première bride, et un dôme 40 fixé à la partie cylindrique. Le premier tronçon 20 est ouvert à son extrémité longitudinale du côté de la première bride 36, et fermé à son autre extrémité longitudinale par le dôme 40.

Le premier tronçon 20 présente une première longueur L1 selon la direction longitudinale X. La première longueur L1 est inférieure à la moitié de la longueur L de l'enceinte selon la direction longitudinale X.

Dans l'exemple de réalisation de la figure 1, la première longueur L1 est inférieure à 0,3 fois la longueur L de l'enceinte, par exemple égale à 0,25 fois la longueur L de l'enceinte. En variante, la première longueur L1 est inférieure à 0,2 fois la longueur L de l'enceinte, de préférence encore inférieure à 0,1 fois la longueur L de l'enceinte.

Le premier tronçon 20 est, par exemple, réalisé en acier, en titane, en une composition hybride d'acier et de béton, ou encore en une composition hybride d'acier et d'un matériau composite, tel que le carbone ou la fibre de verre.

Le deuxième tronçon 22, visible sur les figures 1 et 3, comporte une deuxième bride 42 de fixation du deuxième tronçon au premier tronçon, une partie cylindrique 44 fixée à la deuxième bride, et un dôme 46 fixé à la partie cylindrique.

Le deuxième tronçon 22 comporte deux glissières 48 fixées à l'intérieur du deuxième tronçon de manière diamétralement opposée par rapport à un axe médian M du module, l'axe médian étant parallèle à la direction longitudinale X, comme représenté sur la figure 3.

Le deuxième tronçon 22 est ouvert à son extrémité longitudinale du côté de la deuxième bride de fixation, et fermé à son autre extrémité longitudinale par le dôme 46.

Le deuxième tronçon 22 présente une deuxième longueur L2 selon la direction longitudinale X. La deuxième longueur L2 est strictement supérieure à la première longueur L1.

Dans l'exemple de réalisation de la figure 1, la deuxième longueur L2 est supérieure à 0,7 fois la longueur L de l'enceinte selon la direction longitudinale X, par exemple égale à 0,75 fois la longueur L de l'enceinte. En variante, la deuxième longueur L2 est supérieure à 0,8 fois la longueur L de l'enceinte, de préférence encore supérieure à 0,9 fois la longueur L de l'enceinte.

Le deuxième tronçon 22 est, par exemple, réalisé en acier, en titane, en une composition hybride d'acier et de béton, ou encore en une composition hybride d'acier et d'un matériau composite, tel que le carbone ou la fibre de verre.

La somme de la première longueur L1 et de la deuxième longueur L2 est égale à la longueur L de l'enceinte.

Le joint d'étanchéité 24 est agencé entre les deux brides de fixation 36, 42. Le joint d'étanchéité 24 est, par exemple, un joint plat.

Les moyens de suspension 26 correspondant à une paire d'organes de maintien 16 agencés en la position longitudinale extrême X1 sont diamétralement opposés par rapport à l'axe médian M, comme représenté sur la figure 3.

Les moyens de suspension 26 sont, par exemple, des moyens élastiques. Dans l'exemple de réalisation de la figure 3, les moyens de suspension 26 correspondant à chaque organe de maintien 16 comportent un ressort 50.

Chaque organe de maintien 16 disposé en la position longitudinale extrême X1 comporte une seule liaison mécanique, par exemple celle formée par le ressort 50.

Les moyens d'appui 28 sont, par exemple, des moyens élastiques. Les moyens d'appui 28 sont solidaires d'un longeron longitudinale 30 correspondante et sont répartis successivement le long dudit longeron 30 selon la direction longitudinale X.

Dans l'exemple de réalisation de la figure 2, les moyens d'appui 28 comportent une pluralité de paires de ressorts 52 équipés chacun d'une platine d'appui 54.

Chaque organe de maintien 16 disposé en une position longitudinale Xi autre que ladite position longitudinale extrême X1 comporte deux liaisons mécaniques, par exemple les deux liaisons mécaniques formées par les deux ressorts 52 d'une paire de ressorts.

En complément, les moyens d'appui 28 de la ou chaque paire d'organes de maintien 16 correspondant à une même position longitudinale X2 à X6 autre que la position longitudinale extrême X1 sont diamétralement opposés par rapport à l'axe médian M du module 12.

Les poutres 30, 32 de l'ossature mécanique du module 12 présentent une masse linéique de valeur inférieure à 100 kg/m, de préférence inférieure à 80 kg/m, de préférence encore inférieure à 60 kg par mètre.

Chaque poutre 30, 32 est, par exemple, réalisée en acier, en acier inoxydable, en aluminium, ou encore en matériau composite, tel que le carbone ou la fibre de verre.

Chaque longeron longitudinale 30 présente une section en forme de U, et comporte une âme longitudinale 55 et deux ailes 56 fixées chacune à un bord longitudinal de l'âme 55, comme représenté sur la figure 4.

Chaque traverse 32 présente une section en forme de H. Les extrémités des traverses 32 sont chacune insérées entre les deux ailes 56 du longeron correspondant.

Chaque plateau transversal 34, visible sur la figure 2, comporte un cadre 58 fixé aux longerons.

En complément, chaque plateau transversal 34 comporte la traverse 32 solidaire du cadre, la traverse 32 étant fixée en chacune de ses extrémités à un longeron longitudinale 30 correspondante.

La première bride de fixation 36 est fixée à la deuxième bride de fixation 42 en position de fermeture de l'enceinte. Dans l'exemple de réalisation de la figure 3, la première bride de fixation 36 comporte une pluralité de trous traversants longitudinaux 59 destinés à recevoir des moyens de fixation, non représentés, de la première bride 36 à la deuxième bride 42.

Le dôme 40 est, par exemple, en forme d'une demi-sphère. En variante, le dôme 40 est en forme d'un demi-ellipsoïde.

La deuxième bride de fixation 42, visible sur la figure 3, est fixée à la première bride en position de fermeture de l'enceinte, et comporte une pluralité de trous traversants longitudinaux 59 destinés à recevoir les moyens de fixation, non représentés, de la première bride 36 avec la deuxième bride 42.

Le dôme 46 est, par exemple, en forme d'une demi-sphère. En variante, le dôme 46 est en forme d'un demi-ellipsoïde.

Chaque glissière 48, visible sur la figure 2, comporte une âme 60 et deux plans inclinés 62, l'âme 60 et les plans inclinés 62 s'étendant principalement selon la direction longitudinale X.

Les glissières 48 forment avec les moyens d'appui 28 des moyens complémentaires de coulissement le long de la direction longitudinale X.

Le premier ressort 52 de la paire de ressorts présente une première direction de travail T1, et le deuxième ressort 52 de la paire présente une deuxième direction de travail T2, la direction de travail T1, T2 de chaque ressort 52 étant la direction selon laquelle la force du ressort est supérieure à la force du ressort selon les autres directions. La première direction de travail T1 du premier ressort est perpendiculaire à la deuxième direction de travail T2 du deuxième ressort.

Chaque ressort 52 est fixé entre le longeron 30 et la platine d'appui 54 correspondants.

Chaque platine d'appui 54 est propre à glisser le long de la glissière 48 correspondante selon la direction longitudinale X, et les moyens d'appui 28 sont alors des moyens d'appui glissant.

Le cadre 58 de chaque plateau transversal 34 comporte une pluralité de poutres 64, chaque poutre 64 correspondant à un côté du cadre, comme représenté sur la figure 4.

En variante de l'exemple de réalisation des figures 1 à 3 où chaque organe de maintien 16 est solidaire d'un longeron 30 respectif, au moins un organe de maintien 16 est solidaire d'une poutre 64 respective.

Les plans inclinés 62 forment avec l'âme 60 un angle d'inclinaison I, visible sur la figure 2, sensiblement égal à 45 degrés. Les plans inclinés 62 d'une même glissière sont orientés de telle sorte qu'ils sont perpendiculaires l'un à l'autre, et sont propres à coopérer avec les platines d'appui 54 fixées à une paire de ressorts 52 respective.

Le procédé de fabrication du dispositif de conversion 10 selon l'invention comprend le transport du module électrique de puissance 12 jusqu'au voisinage de l'enceinte 14.

Lors du transport du module électrique 12, celui-ci est maintenu par un outil de maintien, non représenté.

Plus précisément, les organes de maintien 16 maintiennent le module électrique de puissance 12 à l'intérieur de l'outil de maintien lors de l'étape de transport.

L'outil de maintien est, par exemple, un berceau de forme demi-cylindrique sur lequel est disposée l'ossature mécanique 18 par l'intermédiaire des organes de maintien 16, les équipements électriques de puissance du module étant solidaires de l'ossature mécanique 18.

Le procédé de fabrication comprend ensuite l'insertion du module de puissance 12 dans l'enceinte 14, et enfin la fermeture de l'enceinte étanche 14.

Lors de la fermeture de l'enceinte, le deuxième tronçon 22 coulisse le long des longerons 30 de l'ossature mécanique du module de puissance à l'aide des moyens d'appui glissant 28 et des glissières 48 formant moyens complémentaires de coulissement selon la direction longitudinale X.

Le deuxième tronçon 22 est guidé selon la direction longitudinale X jusqu'à ce que la deuxième bride de fixation 42 vienne en appui contre la première bride de fixation 36, et les deux tronçons 20, 22 sont alors fixés entre eux par l'intermédiaire de moyens de fixation, non représentés, entre la première bride 36 et la deuxième bride 42.

Ainsi, le dispositif de conversion 10 selon l'invention permet de réduire la masse du module de puissance 12 en augmentant le nombre de positions longitudinales successives où les organes de maintien 16 sont disposés. En effet, l'augmentation du nombre de positions longitudinales, c'est-à-dire l'augmentation du nombre de points de maintien du module électrique 12 à l'intérieur de l'enceinte étanche 14, permet de proposer une ossature mécanique 18 de rigidité mécanique plus faible. Ceci engendre une diminution de la masse linéique des longerons 30 et des traverses 32 de l'ossature mécanique. A titre d'exemple, la masse linéique de l'ossature mécanique du module de puissance du dispositif de conversion de l'état de la technique est de l'ordre de 130 kg/m alors que la masse linéique de l'ossature mécanique 18 du dispositif de conversion 10 selon l'invention présente une valeur inférieure à 100 kg/m, de préférence inférieure à 80 kg/m, de préférence encore inférieure à 60 kg/m.

La masse de l'ossature mécanique 18 du dispositif de conversion selon l'invention est donc réduite par rapport à celle du dispositif de conversion de l'état de la technique. A titre d'exemple, l'ossature mécanique du module électrique de puissance du dispositif de conversion de l'état de la technique présente une masse sensiblement égale à 7 tonnes alors que l'ossature mécanique 18 du dispositif de conversion 10 selon l'invention présente une masse de l'ordre de 1,5 tonnes. La réduction de la masse de l'ossature mécanique est donc particulièrement importante, puisqu'elle est de l'ordre de 80% par rapport à l'ossature mécanique du dispositif de conversion de l'état de la technique, pour un dispositif de conversion de même puissance électrique et de dimensions similaires en ce qui concerne la longueur et le diamètre de l'enceinte.

En d'autres termes, le nombre N de positions longitudinales Xi supérieur ou égal à 3 permet de proposer un module électrique de puissance 12 avec une ossature mécanique 18 qui n'est pas autoporteuse, et permet alors de réduire de manière importante la masse du dispositif de conversion 10. La réduction de masse du dispositif de conversion est de l'ordre de 5,5 tonnes par rapport au dispositif de conversion de l'état de la technique.

L'ossature mécanique 18 n'étant pas autoporteuse, il est nécessaire de prévoir un outil de maintien pour la manutention du module électrique de puissance 12.

Les moyens d'appui glissant 28 permettent également de faciliter l'insertion du module de puissance 12 dans l'enceinte 14.

On conçoit ainsi que l'invention permet de proposer un dispositif de conversion d'énergie de masse plus faible, tout en délivrant une même puissance électrique.

## Revendications

1. Dispositif (10) de conversion d'énergie électrique pour un système d'entraînement électrique de station sous-marine de compression et de pompage, du type comprenant :
- un module électrique de puissance (12),
- une enceinte étanche (14) de logement du module de puissance (12), l'enceinte étanche (14) s'étendant selon une direction longitudinale (X),
- une pluralité d'organes (16) de maintien du module électrique (12) à l'intérieur de l'enceinte étanche (14), les organes de maintien (16) étant disposés en N positions longitudinales successives (X1 à X6) selon la direction longitudinale (X),
**caractérisé en ce que** le nombre N de positions longitudinales (X1 à X6) successives est un nombre entier supérieur ou égal à 3.

2. Dispositif (10) selon la revendication 1, dans lequel le module électrique de puissance comprend une ossature mécanique comportant deux poutres (30) sensiblement longitudinales et au moins deux poutres transversales (32), chaque poutre transversale (32) reliant mécaniquement les deux poutres longitudinales (30).

3. Dispositif (10) selon la revendication 2, dans lequel la masse linéique des poutres (30, 32) de l'ossature mécanique (18) est inférieure à 100 kg/m, de préférence inférieure à 80 kg/m, de préférence encore inférieure à 60 kg/m.

4. Dispositif (10) selon la revendication 2 ou 3, dans lequel le module électrique de puissance comprend en outre au moins un plateau transversal (34) agencé perpendiculairement aux poutres longitudinales (30), le ou chaque plateau transversal (34) étant solidaire des deux poutres longitudinales (30).

5. Dispositif (10) selon la revendication 4, dans lequel les organes de maintien sont disposés au voisinage de chacune des extrémités des poutres longitudinales (30) et également en regard d'au moins un plateau transversal (34) disposé à l'écart des extrémités des poutres longitudinales (30).

6. Dispositif (10) selon la revendication 5, dans lequel les organes de maintien sont disposés en regard d'une pluralité de plateaux transversaux (34) disposés à l'écart des extrémités des poutres longitudinales (30).

7. Dispositif (10) selon l'une quelconque des revendications précédentes, dans lequel N est un nombre entier supérieur ou égal à 5.

8. Dispositif (10) selon l'une quelconque des revendications précédentes, l'enceinte étanche comportant au moins deux tronçons successifs (20, 22) suivant la direction longitudinale, dans lequel le ou les organe(s) de maintien disposé(s) en l'une (X1) des deux positions longitudinales extrêmes comporte(nt) des moyens (26) de suspension à un tronçon (20) correspondant.

9. Dispositif (10) selon la revendication 8, dans lequel les organes de maintien disposés en des positions longitudinales (X2 à X6) autres que ladite position longitudinale extrême (X1) comportent des moyens (28) d'appui contre l'enceinte (14).

10. Dispositif (10) selon la revendication 9, dans lequel au moins une paire d'organes de maintien (16) est agencée en une position longitudinale (X2 à X6) autre que ladite position longitudinale extrême (X1), les moyens d'appui (28) de la ou chaque paire d'organes de maintien étant diamétralement opposés par rapport à un axe médian (M) du module (12), l'axe médian (M) étant parallèle à la direction longitudinale (X).

11. Procédé de fabrication d'un dispositif (10) selon l'une quelconque des revendications précédentes, comprenant les étapes suivantes :
- le transport du module électrique de puissance (12) jusqu'au voisinage de l'enceinte (14),
- l'insertion du module électrique de puissance (12) dans l'enceinte (14), et
- la fermeture de l'enceinte étanche (14),
le procédé étant **caractérisé en ce qu'**il comprend l'utilisation d'un outil de maintien du module de puissance lors de l'étape de transport, et **en ce que** les organes de maintien (16) maintiennent le module électrique (12) à l'intérieur de l'outil de maintien lors de l'étape de transport.

## Patentansprüche

1. Vorrichtung (10) zur Umwandlung elektrischer Energie für ein elektrisches Antriebssystem einer Unterwasserkompressions- und -pumpstation der Bauart, die aufweist:
- ein elektrisches Leistungsmodul (12),
- ein dichtes Gehäuse (14) zur Aufnahme des Leistungsmoduls (12), wobei sich das dichte Gehäuse (14) entlang einer Längsrichtung (X) erstreckt,
- mehrere Glieder (16) zum Halten des elektrischen Moduls (12) im Inneren des dichten Gehäuses (14), wobei die Halteglieder (16) in N aufeinanderfolgenden Längspositionen (X1 bis X6) entlang der Längsrichtung (X) angeordnet sind,
- **dadurch gekennzeichnet, dass** die Anzahl N der aufeinanderfolgenden Längspositionen (X1 bis X6) eine ganze Zahl größer als oder gleich 3 ist.

2. Vorrichtung (10) nach Anspruch 1, wobei das elektrische Leistungsmodul eine mechanische Konstruktion aufweist, die zwei im Wesentlichen in Längsrichtung verlaufende Träger (30) und wenigstens zwei Querträger (32) aufweist, wobei jeder Querträger (32) die beiden Längsträger (30) mechanisch verbindet.

3. Vorrichtung (10) nach Anspruch 2, wobei die längenbezogene Masse der Träger (30, 32) der mechanischen Konstruktion (18) kleiner als 100 kg/m, vorzugsweise kleiner als 80 kg/m, noch bevorzugter kleiner als 60 kg/m ist.

4. Vorrichtung (10) nach Anspruch 2 oder 3, wobei das elektrische Leistungsmodul ferner wenigstens ein Quertablett (34) aufweist, das senkrecht an den Längsträgern (30) angeordnet ist, wobei das oder jedes Quertablett (34) mit den beiden Längsträgern (30) fest verbunden ist.

5. Vorrichtung nach Anspruch 4, wobei die Halteglieder benachbart zu jedem der Enden der Längsträger (30) angeordnet sind und auch gegenüber wenigstens einem Querträger (34) im Abstand zu den Enden der Längsträger (30) angeordnet sind.

6. Vorrichtung (10) nach Anspruch 5, wobei die Halteglieder gegenüber mehreren Querträgern (34) im Abstand zu den Enden der Längsträger (30) angeordnet sind.

7. Vorrichtung (10) nach einem beliebigen der vorhergehenden Ansprüche, wobei N eine ganze Zahl größer als oder gleich 5 ist.

8. Vorrichtung (10) nach einem beliebigen der vorhergehenden Ansprüche, wobei das dichte Gehäuse wenigstens zwei entlang der Längsrichtung aufeinanderfolgende Abschnitte (20, 22) aufweist, wobei das oder die Halteglied(er), das (die) an einem (X1) der beiden äußeren Längspositionen angeordnet ist (sind), Mittel (26) zur Aufhängung an einem entsprechenden Abschnitt (20) aufweist (aufweisen).

9. Vorrichtung (10) nach Anspruch 8, wobei die Halteglieder, die an anderen Längspositionen (X2 bis X6) als die äußere Längsposition (X1) angeordnet sind, Mittel (28) zur Abstützung gegen das Gehäuse (14) aufweisen.

10. Vorrichtung (10) nach Anspruch 9, wobei wenigstens ein Paar der Haltemittel (16) an einer anderen Längsposition (X2 bis X6) als die äußere Längsposition (X1) angeordnet ist, wobei die Abstützungsmittel (28) des oder jedes Paars Haltemittel in Bezug auf eine Mittelachse (M) dem Modul (12) diametral gegenüberliegend angeordnet sind, wobei die Mittelachse (M) zu der Längsrichtung (X) parallel verläuft.

11. Verfahren zur Herstellung einer Vorrichtung (10) nach einem beliebigen der vorhergehenden Ansprüche, das die folgenden Schritte aufweist:
- Transport des elektrischen Leistungsmoduls (12) bis in die Nähe des Gehäuses (14),
- Einführung des elektrischen Leistungsmoduls (12) in das Gehäuse (14) und
- Verschließen des dichten Gehäuses (14),
wobei das Verfahren **dadurch gekennzeichnet ist, dass** es die Verwendung eines Werkzeugs zur Halterung des Leistungsmoduls während des Transportschrittes aufweist, und dadurch, dass die Halteglieder (16) das elektrische Modul (12) während des Transportschrittes im Inneren des Haltewerkzeugs halten.

## Claims

1. Device (10) for converting electrical power for an electric drive system of a submarine compression and pumping station, of the type comprising:
- an electric power module (12),
- a sealed enclosure (14) housing the power module (12), the sealed enclosure (14) extending in a longitudinal direction (X),
- a plurality of elements (16) for holding the electric module (12) inside the sealed enclosure (14), the holding elements (16) being arranged in N successive longitudinal positions (X1 to X6) in the longitudinal direction (X),
**characterised in that** the number N of successive longitudinal positions (X1 to X6) is an integer greater than or equal to 3.

2. Device (10) according to claim 1, wherein the electric power module comprises a mechanical framework consisting of two substantially longitudinal beams (30) and at least two transverse beams (32), each transverse beam (32) mechanically connecting the two longitudinal beams (30).

3. Device (10) according to claim 2, wherein the linear mass of the beams (30, 32) of the mechanical framework (18) is less than 100 kg/m, preferably less than 80 kg/m, preferably again less than 60 kg/m.

4. Device (10) according to claim 2 or 3, wherein the electric power module also comprises at least one transverse plate (34) arranged perpendicularly to the longitudinal beams (30), the or each transverse plate (34) being attached to two longitudinal beams (30).

5. Device (10) according to claim 4, wherein the holding elements are arranged close to each of the ends of longitudinal beams (30) and also facing at least one transverse plate (34) arranged spaced from the ends of the longitudinal beams (30).

6. Device (10) according to claim 5, wherein the holding elements are arranged facing a plurality of transverse plates (34) arranged spaced from the ends of longitudinal beams (30).

7. Device (10) according to any of the preceding claims, wherein N is an integer greater than or equal to 5.

8. Device (10) according to any of the preceding claims, the sealed enclosure comprising at least two successive portions (20, 22) in the longitudinal direction, wherein the holding element(s) arranged in one (X1) of two end longitudinal positions comprises means (26) for suspension from a corresponding portion (20).

9. Device (10) according to claim 8, wherein the holding elements arranged in longitudinal positions (X2 to X6) other than said end longitudinal position (X1) comprise means (28) for support against the enclosure (14).

10. Device (10) according to claim 9, wherein at least one pair of holding elements (16) is arranged in a longitudinal position (X2 to X6) other than said end longitudinal position (XI), the support means (28) of the or each pair of holding elements being diametrically opposed relative to a median axis (M) of the module (12), the median axis (M) being parallel to the longitudinal direction (X).

11. Method for production of a device (10) according to any of the preceding claims, comprising the following steps:
- transport of the electric power module (12) to the vicinity of the enclosure (14),
- insertion of the electric power module (12) in the enclosure (14), and
- closure of the sealed enclosure (14),
the method being **characterised in that** it comprises the use of a tool for holding the power module during the transport step, and **in that** the holding elements (16) hold the electric module (12) inside the holding tool during the transport step.
